# EUROPEAN PATENT SPECIFICATION

(11) **EP 0 616 223 B1**
(45) Date of publication and mention of the grant of the patent: **20.10.1999**
(21) Application number: 93830099.3
(22) Date of filing: 15.03.1993
(51) Int. Cl.: G01R 31/28, H01L 21/66

(54) **A testing contactor for small-size semiconductor power devices**
Prüfkontakt für kleine Leistungshalbleiter
Contacteur de test pour dispositifs de puissance semi-conducteurs de petite taille

(43) Date of publication of application: 21.09.1994
(73) Proprietor: STMicroelectronics S.r.l., 20041 Agrate Brianza (Milano) (IT)
(72) Inventor: Perego, Romano, I-22050 Calco (Como) (IT)
(74) Representative: Botti, Mario

(56) References cited:
- EP-A- 0 295 007
- US-A- 4 316 231
- US-A- 4 887 969
- PATENT ABSTRACTS OF JAPAN vol. 15, no. 494 (E-1145) 13 December 1991 & JP-A-3 215 956 ( MATSUSHITA ELECTRON CORP ) 20 September 1991

## Description

This invention relates to a testing contactor for semiconductor devices, specifically power devices.

Semiconductor devices comprise a more or less oblate parallelepipedic body whence electrical connection leads are led out. It is common practice to test such devices, before their delivery for sale, one at a time to check that their performance is up to specifications. To this aim, their leads are connected electrically to an automatic test apparatus whereby, inter alia, predetermined currents are supplied across lead pairs, and the voltage drop is measured across the two leads inside the device. Similar tests are also performed manually on individual semiconductor devices for design verification, specific sampled quality checks, or other purposes.

Usually, the test current is supplied with the intermediary of a contactor which carries plural electric contact elements spring loaded toward the leads. The voltage drop is measured across these contact elements.

Power devices may require, however, relatively large currents (on the order of some amperes), such that the contact resistance between the leads and electric contact elements becomes significant. Measuring the voltage drop across the electric contact elements rather than across the leads means to get a value made greater by the two contact resistances.

This would distort the test measurements to a largely unforeseeable extent, since contact resistance is dependent on such deeply varying factors as pressure, actual contact area, surface finish, ambient temperature, cleanliness, etc.

To avoid measuring errors, so-called Kelvin contacts are known to be used.

Kelvin contacts are in practice dual contacts placed side-by-side; one contact element (the "forcing" contact) is used for power supply, and the other contact element (the "sensing" contact) is used for connection to the voltage meter. The voltage drop due to contact resistance through the sensing contacts is negligible, because negligible is the current flowed therethrough.

US-A-4 887 969 discloses an IC housing comprising a socked body having an IC package accomodating space therein; an IC mounting table disposed in the IC package accomodating space and adapted to support an IC package thereon; and a plurality of contacts planted in a socked body portion at the periphery of the mounting table; the plurality of contacts each having a resilient contact piece, IC terminals of the IC package, when the IC package is supported on the mounting table, being able to contact with the resilient contact pieces of the contacts, wherein the IC package mounting table is formed with a plurality of contacts positioning grooves for receiving the resilient contact pieces therein, so that the resilient contact pieces are regulated by a wall for defining the positioning grooves.

Patent Abstracts of Japan, vol.15, no.494 (E-1145), 13.12.1991 discloses an apparatus for testing semiconductor device by a Kelvin type measurement, wherein an external lead is brought into contact with a first and a second contact terminal as pinched between them when a pressing means is made to press the first and the second contact terminal against a holding member.

Unfortunately, there are semiconductor devices, including power devices, whose size is so small that the Kelvin contacts cannot be used with the contact elements laid side-by-side. The only possibility would be that of pressing the two contact elements against the lead from opposite sides thereof; however, this solution is unacceptable because it makes for significantly different lengths of the sensing and forcing path wires, and consequent introduction of errors in tests conducted at high frequencies.

The underlying problem of this invention is to provide a contactor incorporating Kelvin contacts, which can be also used with small-size semiconductor devices, i.e. devices whose leads are less than 5 mm long, less than 1 mm wide, and are spaced less than 2 mm apart.

This problem is solved, according to the invention, by a testing contactor for a small-size semiconductor power device having a plurality of electric connection leads, which contactor comprises a plate and a backplate, both made of an electrically insulative material; a housing for receiving the semiconductor device therein, formed between the plate and the backplate; a plurality of first electric contact elements accommodated on the plate and being each adapted to be held against a respective one of the semiconductor device leads with the backplate closed against the plate; characterized in that it comprises a plurality of electric connection elements accommodated on the backplate, and a plurality of second electric contact elements accommodated on the plate in positions substantially alongside the first electric contact elements, each electric connection element on the backplate comprising on its opposite ends projecting portions respectively held, with the backplate closed against the plate, against a respective one of the semiconductor device leads, on the opposite side from the first electric contact element, and against a respective one of the second electric contact elements; the combination of the first and second electric contact element pair and the electric connection element forming an electric contact of the so-called Kelvin type for a lead of the semiconductor device.

The electric connection elements on the backplate practically form extensions of the leads, thereby enabling the sensing and forcing contacts for each lead to be laid side-by-side.

A contactor so constructed can be used manually or suitable to be used in an automatic test apparatus.

In the former instance, the plate and backplate are hinged together and provided with a closure means, thereby forming a contactor of the manual type.

In the latter instance, the plate is affixed to the test apparatus and the backplate is mounted on a pusher member operative to drive it toward and away from the plate.

The parts in electric contact relationship are advantageously urged toward each other in a resilient fashion. Preferably, the first and second electric contact elements are spring mounted on the plate, whereas the electric connection elements are carried rigidly on the backplate.

This makes for easier manufacture of the contactor, both because elastic contact elements can be used on the plate which are standard available designs, and because the manufacture of the backplate, carrying no elastic elements, is made specially simple.

The leads are frequently coplanar with one another and with a base of the semiconductor device to make the operations for soldering the leads to printed circuits easier. In this case, care should be taken to prevent the testing operations from altering the planar condition. Thus, in such cases, the backplate includes of preference a projection for exerting a pressure on the base, the projection being substantially coplanar with the ends of the electric connection elements.

Further features and advantages of a contactor according to the invention will become more clearly apparent from the following detailed description of a preferred embodiment thereof, given with reference to the accompanying drawings. In the drawings:
Figure 1 is a sectional view of a manual contactor according to the invention in the open condition;
Figure 2 is a top view of the contactor in Figure 1, again in the open condition;
Figure 3 is a sectional view of the contactor in Figure 1, shown in the closed condition with a semiconductor device clamped therein; and
Figure 4 is a sectional view of a contactor according to the invention, as intended for incorporation to an automatic test apparatus.

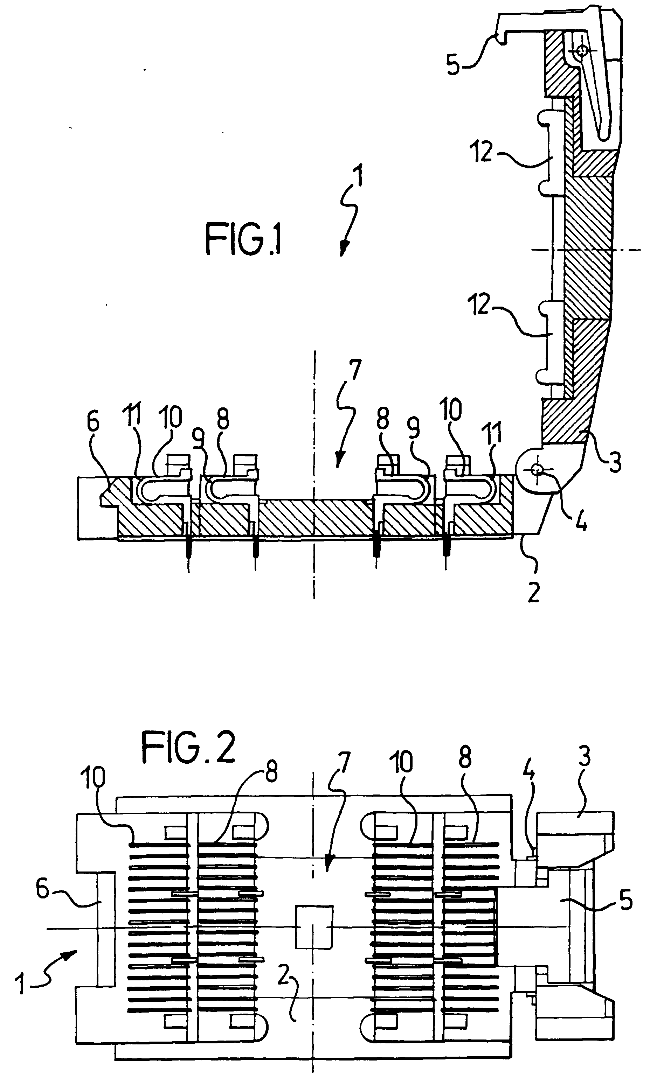

Shown at 1 in Figures 1 to 3 is a manual contactor for testing a semiconductor device D having a plurality of leads L laid in two arrays along two sides of the device D.

The contactor 1 comprises a plate 2 and a backplate 3, both made of an electrically insulative material; the plate 2 and backplate 3 are hinged together about a pivot lead 4 and can be held together by virtue of a hook 5 provided on the backplate 3 being engageable with a catch 6 formed on the plate 2. Formed between the plate 2 and the backplate 3 is a housing 7 for receiving the device D to be tested.

Accommodated on the plate 2 are first electric contact elements 8, laid in two arrays along two sides of the housing 7 at locations which correspond individually to the leads L of the semiconductor device D to be tested. Each electric contact element 8 is spring mounted on the plate 2 by means of an arched portion 9 of the contact element 8 itself, and is biased toward a respective one of the leads L of the device D placed in the housing 7.

Also accommodated on the plate 2 are second electric contact elements 10 laid each alongside one of the first contact elements 8. The contact elements 10 are identical with the contact elements 8 and include likewise an arched spring portion 11.

Accommodated on the backplate 3 are electric connection foil elements 12 which are positioned to correspond each to a pair of contact elements 8 and 10, with the backplate 3 closed against the plate 2. The connection elements 12 are mounted rigidly on the backplate 3 and comprise on their opposite ends projecting portions respectively held against a respective one of the semiconductor device leads, on the opposite side from the first electric contact element 8, and against a respective one of the second electric contact elements 10.

The aggregate of each first contact element 8 with its respective second contact element 10 and the connection element 12 forms a contact of the Kelvin type. The first contact element 8 functions as the forcing contact, i.e. for power supply, and the second contact element 10 with the connection element 12 functions as the sensing contact (i.e., for measuring the voltage drop). The arrangement could be reversed, even though the doubled contact resistance (i.e., between the second contact elements 10 and the connection elements 12, and between the latter and the leads L) would not disturb the sensing phase owing to the currents being negligible there, but would interfere unnecessarily with the forcing phase, where the currents involved may be large.

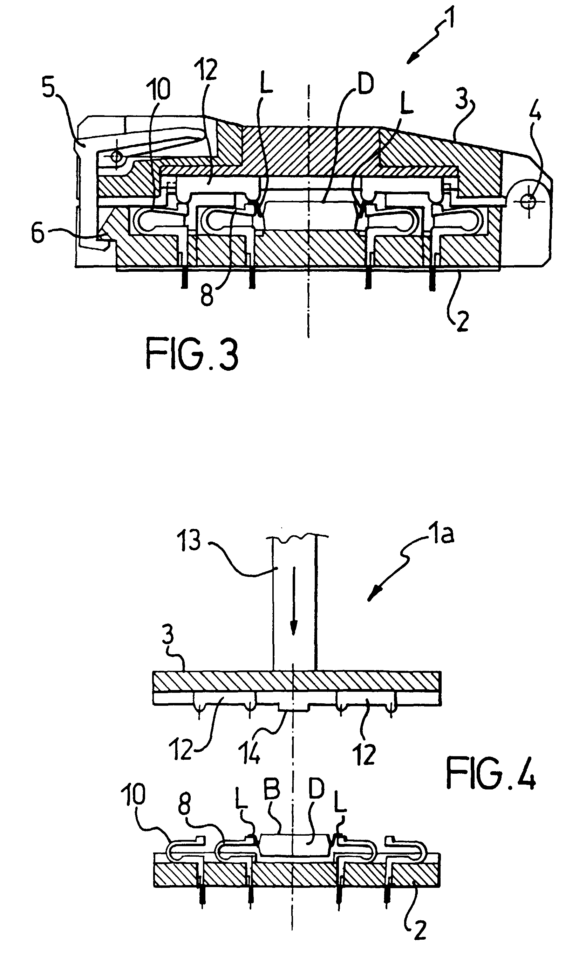

A variation of this invention, shown schematically in Figure 4, provides a contactor 1a for use in an automatic test apparatus (not shown). The contactor la differs from the contactor 1 essentially in that the plate 2 and backplate 3 are independent of rather than hinged to each other; the plate 2 is mounted fixedly on the testing apparatus, and the backplate 3 is mounted on a pusher member (schematically represented by a piston 13 in Figure 4) which drives the backplate 3 toward and away from the plate 2 in a synchronized fashion with the infeed of devices D for testing to the receiving housing 7.

Occasionally, semiconductor devices D may have to be tested which have leads L coplanar with one another and with a base B, and for which the risk of destroying this planarity while testing the device should be avoided. For these situations, with the device D laid with the base B against the backplate 3, a projection 14 may be expediently provided on the backplate 3 at the location of the housing 7, substantially coplanarly with the electric connection elements 12 (in particular, with the ends of the connection elements 12). Such a projection -- which may be formed on the contactor la, as indicated at 14 (Figure 4) -- would exert on the base B the same pressure as the connection elements 12 on each lead L.

The use of the contactors 1 and la can be appreciated from the foregoing. A semiconductor device D to be tested is placed into the housing 7 on the plate 2; the leads L of the device D will bear against the first contact elements 8.

Upon closing the backplate 3 against the plate 2 (manually in the instance of contactor 1 or automatically in the instance of contactor la), the leads L are clamped between the contact elements 8 and the connection elements 12; also, the connection elements 12 are urged against the second contact elements 10.

As a result, both the first contact elements 8 and the second contact elements 10 will become connected electrically to the leads L.

Notice that the electric connection of the first and second contact elements, 8 and 10, occurs on the same side of the contactor, 1 or la, specifically on the side next to the plate 2. This enables the connection and supply wires to be substantially the same length, thereby avoiding any problems from high-frequency testing.

## Claims

1. A testing contactor for a small-size semiconductor power device (D) having a plurality of electric connection leads (L), comprising a plate (2) and a backplate (3), both made of an electrically insulative material; a housing (7) for receiving the semiconductor device (D) therein, formed between the plate (2) and the backplate (3); a plurality of first electric contact elements (8) accommodated on the plate (2) and being each adapted to be held against a respective one of the semiconductor device (D) leads (L) with the backplate (3) closed against the plate (2); characterized in that it comprises a plurality of electric connection elements (12) accommodated on the backplate (3), and a plurality of second electric contact elements (10) accommodated on the plate (2) in positions substantially alongside the first electric contact elements (8), each electric connection element (12) on the backplate (3) comprising on its opposite ends projecting portions respectively held, with the backplate (3) closed against the plate (2), against a respective one of the semiconductor device (D) leads (L), on the opposite side from the first electric contact element (8), and against a respective one of the second electric contact elements (10); the combination of the first (8) and second (10) electric contact element pair and the electric connection element (12) forming an electric contact of the so-called Kelvin type for a lead (L) of the semiconductor device (D).

2. A testing contactor according to Claim 1, wherein the plate (2) and backplate (3) are hinged to each other and provided with a closure means (5,6), thereby forming a manual operation contactor.

3. A testing contactor according to Claim 1 and suitable to be used in an automatic test apparatus, wherein the plate (2) is fixed in the test apparatus and the backplate (3) is mounted on a pusher member (13) operative to drive it toward and away from the plate (2).

4. A testing contactor according to Claim 1, wherein the first (8) and second (10) electric contact elements are spring mounted on the plate (2), whereas the electric connection elements (12) are carried rigidly on the backplate (3) .

5. A testing contactor according to Claim 4, for a semiconductor device (D) having leads (L) which are coplanar with one another and with a base (B) of said device, said device (D) being inserted into the contactor (1,1a) with the base (B) facing the backplate (3), wherein the backplate (3) is provided with a projection (14) adapted to be urged against the base (B), the projection (14) being substantially coplanar with the projecting portions of the electric connection elements (12).

## Patentansprüche

1. Prüfkontakteinrichtung für eine klein dimensionierte Halbleiter-Leistungsvorrichtung (D), die eine Mehrzahl von elektrischen Verbindungsleitungen (L) aufweist, mit einer Platte (2) und einer Rückenplatte (3), die beide aus einem elektrisch isolierenden Material hergestellt sind; mit einem zwischen der Platte (2) und der Rückenplatte (3) ausgebildeten Gehäuse (7) zum darin Aufnehmen der Halbleitervorrichtung (D); mit einer Mehrzahl von ersten elektrischen Kontaktelementen (8), die auf der Platte (2) untergebracht sind und jeweils dazu ausgebildet sind, bei gegen die Platte (2) geschlossener Rückenplatte (3) gegen eine jeweilige Leitung (L) der Halbleitervorrichtung (D) gehalten zu werden;
dadurch gekennzeichnet, daß sie eine Mehrzahl von elektrischen Verbindungselementen (12) aufweist, die auf der Rückenplatte (3) untergebracht sind, sowie eine Mehrzahl von zweiten elektrischen Kontaktelementen (10) aufweist, die auf der Platte (2) in Positionen im wesentlichen längs der ersten elektrischen Kontaktelemente (8) untergebracht sind, wobei jedes elektrische Verbindungselement (12) auf der Rückenplatte (3) an seinen einander gegenüberliegenden Enden vorspringende Bereiche aufweist, die bei gegen die Platte (2) geschlossener Rückenplatte (3) jeweils gegen eine jeweilige Leitung (L) der Halbleitervorrichtung (D) auf der dem ersten elektrischen Kontaktelement (8) gegenüberliegenden Seite sowie gegen ein jeweiliges zweites Kontaktelement (10) gehalten sind; wobei die Kombination aus dem ersten (8) und dem zweiten (10) elektrischen Kontaktelementpaar und dem elektrischen Verbindungselement (12) einen elektrischen Kontakt des sogenannten Kelvin-Typs für eine Leitung (L) der Halbleitervorrichtung (D) bildet.

2. Prüfkontakteinrichtung nach Anspruch 1,
wobei die Platte (2) und die Rückenplatte (3) gelenkig miteinander verbunden und mit einer Verschlußeinrichtung (5, 6) versehen sind, so daß eine Prüfkontakteinrichtung für manuelle Betätigung gebildet ist.

3. Prüfkontakteinrichtung nach Anspruch 1, die zur Verwendung in einer automatischen Prüfvorrichtung geeignet ist, wobei die Platte (2) in der Prüfvorrichtung befestigt ist und die Rückenplatte (3) an einem Drückelement (13) angebracht ist, das eine Bewegung derselben auf die Platte (2) zu sowie von dieser weg bewirkt.

4. Prüfkontakteinrichtung nach Anspruch 1,
wobei die ersten (8) und die zweiten elektrischen Kontaktelemente (10) auf der Platte (2) federnd angebracht sind, während die elektrischen Verbindungselemente (12) an der Rückenplatte (3) starr getragen sind.

5. Prüfkontakteinrichtung nach Anspruch 4 für eine Halbleitervorrichtung (D) mit Leitungen (L), die koplanar zueinander und zu einer Basis (B) der Vorrichtung sind, wobei die Vorrichtung (D) derart in die Prüfeinrichtung (1, la) eingesetzt wird, daß die Basis (B) der Rückenplatte (3) zugewandt ist, wobei die Rückenplatte (3) mit einem Vorsprung (14) versehen ist, der dazu ausgebildet ist, gegen die Basis (B) gedrückt zu werden, wobei der Vorsprung (14) im wesentlichen koplanar zu den vorspringenden Bereichen der elektrischen Verbindungselemente (12) ist.

## Revendications

1. Un contacteur de test pour un dispositif de puissance semi-conducteur de petite taille (D) ayant une pluralité de conducteurs de connexion électrique (L), comprenant une plaque (2) et une contre-plaque (3), toutes deux en matériau électriquement isolant ; un logement (7) pour recevoir le dispositif semi-conducteur (D), formé entre la plaque (2) et la contre-plaque (3) ; une pluralité de premiers éléments de contact électrique (8) montés sur la plaque (2) et étant chacun adapté pour être maintenu contre l'un respectivement des conducteurs (L) du dispositif semi-conducteur (D) lorsque la contre-plaque (3) est refermée sur la plaque (2) ; caractérisé en ce qu'il comprend une pluralité d'éléments de connexion électrique (12) montés sur la contre-plaque (3), et une pluralité de seconds éléments de contact électrique (10) montés sur la plaque (2) dans des positions sensiblement d'alignement côte à côte avec les premiers éléments de contact électrique (8), chaque élément de connexion électrique (12) sur la contre-plaque (3) comprenant en ses extrémités opposées des parties saillantes respectivement maintenues, lorsque la contre-plaque (3) est refermée contre la plaque (2), contre l'un respectivement des conducteurs (L) du dispositif semi-conducteur (D), sur le côté opposé par rapport au premier éléments de contact électrique (8), et contre l'un respectivement des seconds éléments de contact électrique (10) ; la combinaison de la paire de premier (8) et second (10) éléments de contact électrique et de l'élément de connexion électrique (12) formant un contact électrique dit de type Kelvin pour un conducteur (L) du dispositif semi-conducteur (D).

2. Un contacteur de test selon la revendication 1, dans lequel la plaque (2) et la conre-plaque (3) sont articulées l'une à l'autre et pourvues d'un moyen de fermeture (5, 6) pour former un contacteur à fonctionnement manuel.

3. Un contacteur de test selon la revendication 1 et adapté pour être utilisé dans un dispositif de test automatique, dans lequel la plaque (2) est fixée dans le dispositif de test et la contre-plaque (3) est montée sur un élément pousseur (13) actionnable pour la rapprocher et l'éloigner de la plaque (2).

4. Un contacteur de test selon la revendication 1, dans lequel les premier (8) et second (10) éléments de contact électrique sont montés élastiquement sur la plaque (2), tandis que les éléments de connexion électrique (12) sont portés rigidement sur la contre-plaque (3).

5. Un contacteur de test selon la revendication 4, pour un dispositif semi-conducteur (D) ayant des conducteurs (L) qui sont tous dans le même plan qu'une base (B) dudit dispositif, ledit dispositif (D) étant inséré dans le contacteur (1, la) avec sa base (B) en regard de la contre-plaque (3), dans lequel la contre-plaque (3) présente un bossage (14) prévu pour être appuyé contre la base (B), le bossage (14) étant sensiblement coplanaire avec les parties en saillie des éléments de connexion électrique (12).
